(19) **Europäisches Patentamt / European Patent Office / Office européen des brevets**

(11) **EP 4 564 632 A1**

(12) # EUROPEAN PATENT APPLICATION

(43) Date of publication:
04.06.2025 Bulletin 2025/23

(21) Application number: 24215418.5

(22) Date of filing: 26.11.2024

(51) International Patent Classification (IPC):
$H02J\ 3/00$ (2006.01)

(52) Cooperative Patent Classification (CPC):
H02J 3/0012

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 30.11.2023 US 202363604452 P
04.11.2024 US 202418936776

(71) Applicant: **Vertiv Corporation**
**Westerville, OH 43082 (US)**

(72) Inventors:
• **FERGUSON, Kevin R.**
**Westerville (US)**
• **STUCZYNSKI, Marek**
**Westerville (US)**
• **COOPER, Scott**
**Westerville (US)**

(74) Representative: **Beal, James Michael**
**Kilburn & Strode LLP**
**Lacon London**
**84 Theobalds Road**
**London WC1X 8NL (GB)**

(54) **DEVICE PROFILING AND PREDICTIVE FAILURE ANALYSIS USING DISCRETE WAVELET TRANSFORMS**

(57) A power system may receive power signals for one or more monitored devices, where a respective power signal includes at least one of a current or a voltage; perform discrete wavelet transforms (DWTs) of the power signals to generate DWT coefficients associated with the power signals; classify the power signals within two or more classes based on the DWT coefficients, where the two or more classes include one or more normal classes associated with one or more acceptable operational conditions and one or more atypical classes associated with one or more atypical operational conditions; and generate one or more alert signals based on the classified power signals when one or more alert conditions are met.

EP 4 564 632 A1

## Description

### CROSS-REFERENCE TO RELATED APPLICATION

The present application claims the benefit of U.S. Provisional Application Serial Number 63/604,452, filed November 30, 2023, entitled DEVICE PROFILING AND PREDICTIVE FAILURE ANALYSIS USING DISCRETE WAVELET TRANSFORMS, and of U.S. Non-Provisional Application Serial Number 18/936,776, filed November 4, 2024.

### TECHNICAL FIELD

The present disclosure relates generally to failure analysis for electronic systems and, more particularly, to device profiling and failure prediction based on wavelet transform analysis coupled with machine learning models.

### BACKGROUND

Equipment failure often occurs without apparent warning and can result in loss of business revenue caused by downtime or unexpected repair costs. In some cases, equipment may result in a consequential circuit overload and wide outages. Further, it is often not possible to automatically identify what equipment is connected to a particular power feed, which can result in issues such as misallocated energy accounting and unexpected equipment power off when an incorrect power feed is turned off. There is therefore a need to develop systems and methods to cure the above deficiencies.

### SUMMARY

In embodiments, the techniques described herein relate to a power system including one or more controllers including one or more processors configured to execute program instructions stored on one or more memory devices, where the program instructions are configured to cause the one or more processors of the one or more controllers to receive power signals for one or more monitored devices, where a respective power signal includes at least one of a current or a voltage; perform discrete wavelet transforms (DWTs) of the power signals to generate DWT coefficients associated with the power signals; classify the power signals within two or more classes based on the DWT coefficients, where the two or more classes include one or more normal classes associated with one or more acceptable operational conditions and one or more atypical classes associated with one or more atypical operational conditions; and generate one or more alert signals based on the classified power signals when one or more alert conditions are met.
In embodiments, the techniques described herein relate to a power system, further including at least one of current or voltage sensing circuitry to generate the power signals for at least one of the one or more monitored devices.
In embodiments, the techniques described herein relate to a power system, where the power signal for at least one of the one or more monitored devices is received from in-line monitoring circuitry.
In embodiments, the techniques described herein relate to a power system, where the power signals correspond to signals between one or more output loads and one or more outlets of a power distribution subsystem including circuitry to distribute input power to the one or more outlets, where the one or more monitored devices include the one or more output loads, where the one or more controllers include one or more power output modules (POMs) configured to be communicatively coupled to the one or more outlets, where the one or more POMs are configured to receive the power signals, perform the DWTs of the power signals to generate the DWT coefficients associated with the power signals, and classify the power signals within the two or more classes based on the DWT coefficients; and an interchangeable monitoring device (IMD) configured to be communicatively coupled with the one or more POMs, where the IMD is configured to generate the one or more alert signals based on the classified power signals when the one or more alert conditions are met.
In embodiments, the techniques described herein relate to a power system, where the power signals correspond to signals from an input source, where the one or more monitored devices include the input source, where the one or more controllers include one or more power input modules (PIMs) configured to receive the power signals, perform the DWTs of the power signals to generate the DWT coefficients associated with the power signals, and classify the power signals within the two or more classes based on the DWT coefficients; and an interchangeable monitoring device (IMD) configured to be communicatively coupled with the one or more PIMs, where the IMD is configured to generate the one or more alert signals based on the classified power signals when the one or more alert conditions are met.
In embodiments, the techniques described herein relate to a power system, where the two or more classes include a binary set of classes, where the one or more normal classes include a single normal class, where the one or more atypical classes include a single atypical class.
In embodiments, the techniques described herein relate to a power system, where the two or more classes include two or more sets of classes, where each of the two or more sets of classes corresponds to a different one of one or more device types, where each of the two or more sets of classes includes at least one of the one or more normal classes and at least one of the one or more atypical classes.
In embodiments, the techniques described herein relate to a power system, where the one or more alert conditions include classification of at least one of the power signals into a class associated with a different one of the one or more device types than an expected device type.

In embodiments, the techniques described herein relate to a power system, where the one or more alert conditions include classification of at least one of the power signals into one of the one or more atypical classes.

In embodiments, the techniques described herein relate to a power system, where classifying the power signals within the two or more classes based on the DWT coefficients includes classifying the power signals within the two or more classes based on the DWT coefficients by comparing the DWT coefficients to reference DWT coefficients using one or more metrics.

In embodiments, the techniques described herein relate to a power system, where the one or more metrics include at least one of a Pearson's correlation coefficient or a normalized root mean-square error.

In embodiments, the techniques described herein relate to a power system, where the reference DWT coefficients are generated based on one or more of the power signals from one or more of the monitored devices in a normal condition.

In embodiments, the techniques described herein relate to a power system, where classifying the power signals within the two or more classes based on the DWT coefficients includes classifying the power signals within the two or more classes based on the DWT coefficients using a machine learning model that accepts the DWT coefficients as inputs.

In embodiments, the techniques described herein relate to a power system, where the machine learning model is trained on training data including at least one of labeled DWT coefficients associated with the two or more classes or RMS data associated with the one or more monitoring devices.

In embodiments, the techniques described herein relate to a power system, where at least some of the labeled DWT coefficients associated with the two or more classes are associated with historical power signals generated by at least one of in-line monitoring circuitry or a data lake.

In embodiments, the techniques described herein relate to a power system, where the power signals correspond to signals between one or more output loads and one or more outlets of a power distribution subsystem including circuitry to distribute input power to the one or more outlets, where the one or more monitored devices include the one or more output loads, where the one or more controllers include one or more power output modules (POMs) configured to be communicatively coupled to the one or more outlets, where the one or more POMs are configured to receive the power signals, perform the DWTs of the power signals to generate the DWT coefficients associated with the power signals, and classify the power signals within the two or more classes based on the DWT coefficients; and an interchangeable monitoring device (IMD) configured to be communicatively coupled with the one or more POMs, where the IMD is configured to generate the one or more alert signals based on the classified power signals when the one or more alert conditions are met.

In embodiments, the techniques described herein relate to a power system, where the power signals correspond to signals from an input source, where the one or more monitored devices include the input source, where the one or more controllers include one or more power input modules (PIMs) configured to receive the power signals, perform the DWTs of the power signals to generate the DWT coefficients associated with the power signals, and classify the power signals within the two or more classes based on the DWT coefficients; and an interchangeable monitoring device (IMD) configured to be communicatively coupled with the one or more PIMs, where the IMD is configured to generate the one or more alert signals based on the classified power signals when the one or more alert conditions are met.

In embodiments, the techniques described herein relate to a power system, where at least one of the one or more alert signals triggers at least one of a visual indicator, an audio indicator, or a remote indicator.

In embodiments, the techniques described herein relate to a power system, where at least one of the one or more alert signals directs disconnection of power to at least one of the monitoring devices.

In embodiments, the techniques described herein relate to a power monitoring method including receiving power signals for one or more monitored devices, where a respective power signal includes at least one of a current or a voltage; performing discrete wavelet transforms (DWTs) of the power signals to generate DWT coefficients associated with the power signals; classifying the power signals within two or more classes based on the DWT coefficients, where the two or more classes include one or more normal classes associated with one or more acceptable operational conditions and one or more atypical classes associated with one or more atypical operational conditions; and generating one or more alert signals based on the classified power signals when one or more alert conditions are met.

It is to be understood that both the foregoing general description and the following detailed description are exemplary and explanatory only and are not necessarily restrictive of the invention as claimed. The accompanying drawings, which are incorporated in and constitute a part of the specification, illustrate embodiments of the invention and together with the general description, serve to explain the principles of the invention.

## BRIEF DESCRIPTION OF DRAWINGS

The numerous advantages of the disclosure may be better understood by those skilled in the art by reference to the accompanying figures.

FIG. 1 is a block diagram illustrating a power system, in accordance with one or more embodiments of the present disclosure.

FIG. 2 is a block diagram view of a power input module (PIM), in accordance with one or more embodiments of the present disclosure.

FIG. 3 is a block diagram view of a power output module (POM), in accordance with one or more embodiments of the present disclosure.

FIG. 4 is a block diagram view of an interchangeable monitoring device (IMD), in accordance with one or more embodiments of the present disclosure.

FIG. 5 is a flow diagram illustrating steps performed in a method for classifying monitored devices, in accordance with one or more embodiments of the present disclosure.

FIG. 6A includes a time-scale plot and a plot of discrete wavelet transform (DWT) coefficients for a power signal and a reference signal, where the reference signal is identical to the power signal, in accordance with one or more embodiments of the present disclosure.

FIG. 6B includes a time-scale plot 606 and a plot 608 of DWT coefficients for a power signal and a reference signal, where the reference signal is phase shifted relative to the power signal by five degrees, in accordance with one or more embodiments of the present disclosure.

FIG. 6C includes a time-scale plot and a plot of DWT coefficients for a power signal and a reference signal, where the reference signal is phase shifted relative to the power signal by 180 degrees, in accordance with one or more embodiments of the present disclosure.

FIG. 6D includes a time-scale plot and a plot of DWT coefficients for a power signal and a reference signal, where the reference signal has half the amplitude of the power signal, in accordance with one or more embodiments of the present disclosure.

FIG. 6E includes a time-scale plot and a plot of DWT coefficients for a power signal and a reference signal, where the reference signal has two temporal and spatial anomalies, in accordance with one or more embodiments of the present disclosure.

FIG. 6F includes a time-scale plot and a plot of DWT coefficients for a power signal and a reference signal, where both signals are a combination of a fundamental and a third harmonic signal, but where the reference signal is a different amplitude of the third harmonic signal, in accordance with one or more embodiments of the present disclosure.

FIG. 6G includes a time-scale plot and a plot of DWT coefficients for a power signal and a reference signal, where both signals are a combination of a fundamental and a high-order 32-harmonic signal, but where the reference signal includes a spatial anomaly.

FIG. 7 is a flow diagram depicting classification of a power signal based on comparing associated DWT coefficients to reference coefficients is described in greater detail, in accordance with one or more embodiments of the present disclosure.

FIG. 8 is a flow diagram depicting classification using a machine learning model, in accordance with one or more embodiments of the present disclosure.

FIG. 9 includes a plot of a power signal of a fan, a plot of the fan plus a power supply unit (PSU), along with a zoomed plot and an expanded plot of the associated DWT coefficients, in accordance with one or more embodiments of the present disclosure.

FIG. 10 includes a plot of a power signal of a fan plus a heater, a plot of the fan, the heater, and a rack power distribution unit (RPDU), along with a zoomed plot and an expanded plot of the associated DWT coefficients, in accordance with one or more embodiments of the present disclosure.

## DETAILED DESCRIPTION

Reference will now be made in detail to the subject matter disclosed, which is illustrated in the accompanying drawings. The present disclosure has been particularly shown and described with respect to certain embodiments and specific features thereof. The embodiments set forth herein are taken to be illustrative rather than limiting. It should be readily apparent to those of ordinary skill in the art that various changes and modifications in form and detail may be made without departing from the spirit and scope of the disclosure.

Embodiments of the present disclosure are directed to systems and methods providing classification of power signals and associated devices based on discrete wavelet transforms (DWTs) of the power signals including, where the possible classes include one or more normal classes associated with acceptable operational conditions of the devices and one or more atypical classes associated with atypical operational conditions. The atypical operational conditions may correspond to failure conditions and/or pre-failure conditions that may lead to failure of the associated devices. In some embodiments, the power signals are associated with input and/or output power signals to a power distribution unit (PDU). Further, the power signals may correspond to time-series current and/or voltage signals. In particular, the power signals may correspond to digitized and/or sampled versions of current and/or voltage signals.

Embodiments of the present disclosure are further directed to generating one or more alert signals (e.g., lights, sounds, interrupts, maintenance requests, or the like) under various alert conditions. For example, alerts may be generated when power signals in an atypical class are identified. As another example, alerts may be generated when a device type determined based on the power signals is unexpected, incorrect, or differs from a user-provided device type. It is contemplated that the systems and methods disclosed herein may provide predictive failure analysis and device profiling more generally for connected devices. For example, the systems and methods disclosed herein may identify when a connected device is operating in an atypical manner based on the power signal to and/or from that device. Associated alerts may signal for various actions including, but not limited to, user intervention, disconnection of the device (either manually by a user or automatically based on the classification), replacement of the device, repair of the device, or maintenance of the device.

The systems and methods disclosed herein may provide any number of classifications or sub-classifications of the power signals and thus the connected devices (e.g., an input source and/or output loads). In some embodiments, power signals are classified using a binary-class classification system to discriminate between a single normal class and a single atypical class. Such a configuration may be well suited for, but not limited to, characterizing devices of a common type, where an alert of atypical behavior is desired. In some embodiments, power signals are classified using a multi-class classification system including a single normal class (e.g., a baseline signature) and multiple atypical classes. Such a configuration may be well suited for, but not limited to, characterizing devices of a common type, where discrimination between different atypical classes is desired. For instance, different atypical classes may be associated with different failure mechanisms and/or different pre-failure conditions.

In some embodiments, power signals are further classified based on device type (e.g., variations of an input source and/or output loads). For example, systems and methods disclosed herein may first identify a device type associated with a power signal (e.g., distinguish between different types of devices) and then provide classification (or sub-classification) into one or more normal classes and/or one or more atypical classes for each device type. It is contemplated herein that different device types may have different baseline power signals (e.g., signatures) and may further have different failure conditions. In this way, different normal and/or atypical conditions may be defined for the different classes. Further, the device type may be known or unknown during classification. For example, when the device type of a particular device is known, this information may be used to limit the available classes used when classifying the associated power signal. However, when the device type of a particular device is unknown, systems and methods disclosed herein may both identify the device type and classify its operational status.

The systems and methods disclosed herein may further provide confidence metrics associated with any classifications. For example, a machine learning model may generate probabilities that a particular power signal belongs to any number of classes. In cases where a machine learning model indicates similar probabilities that a particular power signal may belong to multiple classes, such information may be used in various ways. In some cases, this may be an indication that the machine learning model may benefit from additional training to discriminate between the associated classes. In some cases, this may be an indication that an additional class (e.g., an additional operational condition, an additional device type, or the like) is present that was not considered when developing the machine learning model. In some cases, such a power signal may be assigned a low confidence or be placed into an additional class indicating uncertain results.

It is further contemplated herein that classifying power signals based on DWT coefficients may provide a robust and efficient basis for classification. In particular, DWT techniques may correspond to a feature extraction technique in which DWT coefficients are extracted features that are sensitive to variations in operational conditions and/or device type. Further, a key advantage of wavelet transform techniques compared to alternatives such as the Fourier Transform is the ability to extract local spectral and temporal information simultaneously, which is reflected in DWT coefficients. For instance, Fourier Transform techniques may be highly sensitive to frequency content of power signals but are insensitive to spatial patterns within this frequency content. As an illustration, consider a power signal having different frequency components within different time bands of a sample window (e.g., temporally varying frequency content). It is contemplated herein that spatial variations of frequency content in power signals may be useful for classifying devices by operational conditions and/or device type. However, while Fourier Transform techniques may capture the various frequencies across the sample window, they provide little insight into the spatial variation within the sample window. DWT analysis in contrast may capture such temporal variations and may thus provide a more sensitive basis for classifying power signals.

The systems and methods disclosed herein may utilize any suitable classification technique.

In some embodiments, a power signal of a connected device is classified using a rule-based technique in which DWT coefficients of the power signal are compared to reference DWT coefficients using one or more metrics such as, but not limited to, Pearson's correlation coefficient (PCC) or normalized root mean-square error (NRMSE). In some cases, the DWT coefficients may be pre-processed (e.g., normalized, scaled, filtered, or the like) prior to the comparison. Further, different sets of reference DWT coefficients may be generated that correspond to any number of classes.

In some embodiments, a power signal of a connected device is classified using a machine learning model (e.g., a machine learning classifier, or the like). Such a machine learning model may utilize any type of learning technique known in the art including, but not limited to, supervised learning, unsupervised learning, or reinforcement learning. In the case of supervised learning and/or reinforcement learning, the machine learning model may be trained on training data from a wide range of sources including, but not limited to, synthesized training data or historical data. Further, such historical data may be stored locally or externally (e.g., in a data lake).

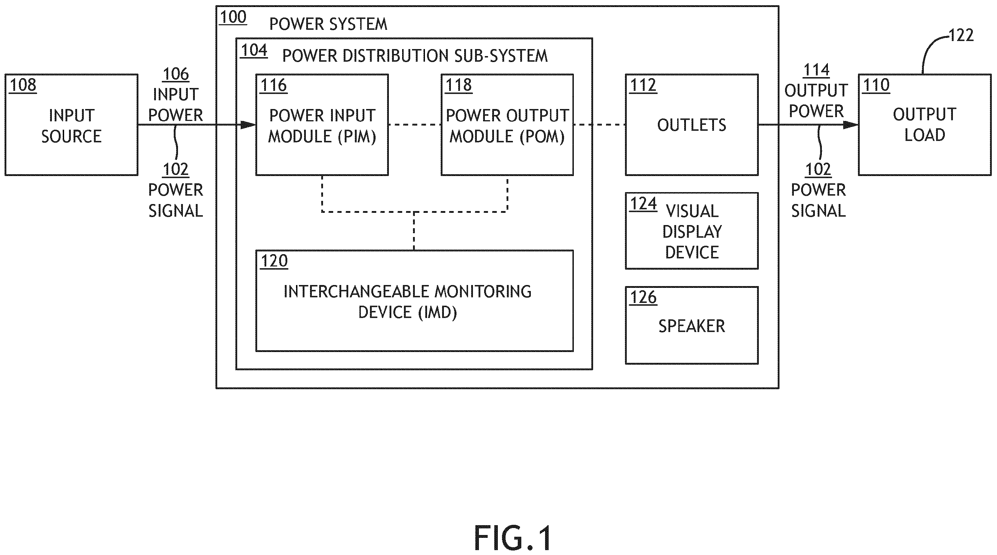

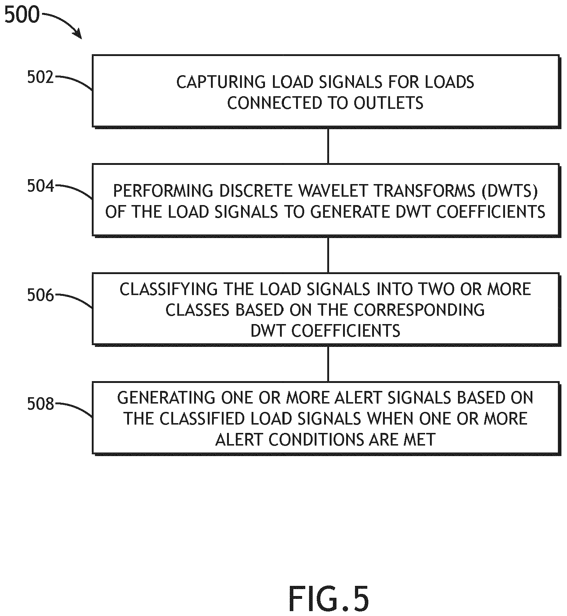

Referring now to FIGS. 1-10, systems and methods for device classification are described in greater detail, in accordance with one or more embodiments of the present disclosure. In particular, FIGS. 1-4 depict a power system 100 suitable for distributing power, while FIGS. 5-8 depict process steps for classifying power signals 102 associated with input and/or output power (e.g., to and/or from the power system 100). The power system 100 may be, but is not required to be, formed as or integrated within a power distribution unit (PDU).

FIG. 1 is a block diagram illustrating a power system 100, in accordance with one or more embodiments of the present disclosure. In embodiments, the power system 100 includes a power distribution sub-system 104 including various electrical components to selectively distribute input power 106 from an input source 108 to any number of output loads 110 connected to any number of outlets 112 as output power 114. The power distribution sub-system 104 may include any combination of passive or active electrical components suitable for distributing the input power 106 to the various outlets 112 to provide output power 114 to any number of output loads 110 such as, but not limited to, transistors, relays, amplifiers, voltage converters, rectifiers, alternating current (AC) to direct current (DC) converters, DC to AC converters, DC to DC converters, or the like. The power distribution sub-system 104 may further include one or more controllers to direct and/or control (e.g., via control signals) such components to selectively distribute the input power 106 to the various outlets 112 and thus the connected output loads 110. The outlets 112 may include plugs or other receptacles configured to provide electrical connections to various output loads 110.

FIG. 1 depicts a particular non-limiting configuration of a power system 100 including a power input module (PIM) 116 configured to accept the input power 106 and at least one power output module (POM) 118 coupled to the outlets 112. In this configuration, a PIM 116 and/or a POM 118 may incorporate both electrical components and a controller.

A particular POM 118 may be connected to and may control the distribution of power to any number of outlets 112. Further, the power system 100 may include any number of POMs 118 and associated outlets 112. Put another way, the outlets 112 may be distributed between any number of POMs 118. In this way, the power system 100 may selectively distribute received input power 106 to any output loads 110 connected to corresponding outlets 112 via the combined operation of the PIM 116 and corresponding POMs 118. In embodiments, the power system 100 further includes at least one controller to receive data from and/or direct (e.g., via control signals) the PIM 116 and various POMs 118. For example, FIG. 1 depicts a non-limiting configuration of an interchangeable monitoring device (IMD) 120, which may be communicatively coupled with the one or more PIMs 116 and the one or more POMs 118. Such a controller may be, but is not required to be, interchangeable or removable. The term interchangeable in the acronym IMD 120 is thus merely illustrative and should not be interpreted as limiting the scope of the present disclosure. Further, FIG. 1 depicts a power system 100 having a single PIM 116, a single POM 118 connected to multiple outlets 112, and a single IMD 120. This configuration is also merely illustrative and should not be interpreted as limiting on the present disclosure. A power system 100 may generally have any number of PIMs 116, POMs 118, IMDs 120, or any other controllers.

The power system 100 may further include circuitry to capture, collect, and/or receive power signals 102 associated with one or more monitored devices 122 of interest. For example, the power signals 102 may correspond to digitized versions of signals associated with power transfer between the monitored devices 122 and the power system 100 in either direction. As an illustration, analog signals associated with power transfer between the monitored devices 122 and the power system 100 may be sampled at discrete times to generate discrete power signals 102. As another illustration, analog signals associated with power transfer between the monitored devices 122 and the power system 100 may be processed by an analog to digital converter to generate discrete power signals 102.

In some embodiments, the power signals 102 are associated with the input power 106 and classification of such power signals 102 may provide classification of the input source 108 (e.g., a monitored device 122 of interest). In some embodiments, the power signals 102 are associated with the output power 114 and classification of such power signals 102 may provide classification of the associated output loads 110 (e.g., monitored devices 122 of interest). In this way, the term monitored device 122 may refer to an input source 108 and/or an output load 110.

The power signals 102 may be captured using any suitable technique. For example, one or more POMs 118 may capture power signals 102 associated with output loads 110. As another example, one or more PIMs 116 may capture power signals 102 associated with the input source 108. As another example, the power system 100 may include dedicated monitoring circuitry to capture the power signals 102. As another example, the power system 100 may receive (e.g., via one or more data ports) the power signals 102 for at least some connected monitored devices 122 from in-line monitoring circuitry or external sources.

The power system 100 may further include one or more components to provide visual and/or audio signals to a user. Such components may be suitable for alerting a user to a status of one or more connected monitored devices 122 such as, but not limited to, an indication of when a monitored device 122 is classified into an atypical class, corresponds to an unexpected device type, or any other alert condition.

For example, the power system 100 may include one or more visual display devices 124. In some embodiments, the one or more visual display devices 124 include a display screen, which may provide any combination of text or graphical information. Further, a backlight or displayed background on a display screen may flash or show a selected color to provide additional information or alerts.

In some embodiments, the one or more visual display devices 124 include one or more light emitting diodes (LEDs), which may provide information based on color brightness, flashing, or the like. In some cases, the power system 100 includes one or more LEDs associated with each outlet 112 (or at least one outlet 112) to provide separate visual indications for the associated monitored devices 122. As another example, the power system 100 may include one or more speakers 126 to provide audio signals such as, but not limited to, sounds or spoken text.

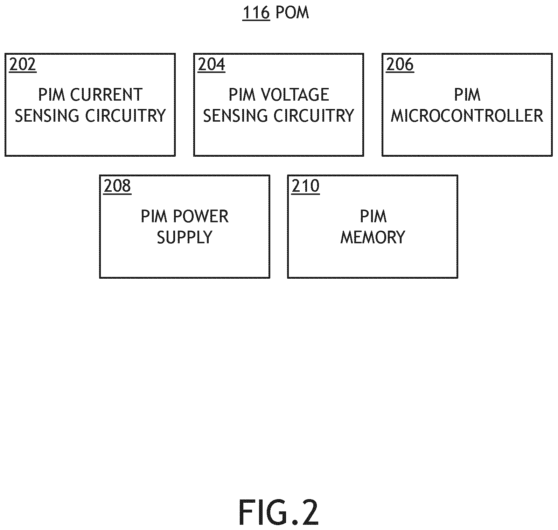

FIG. 2 is a block diagram view of a PIM 116, in accordance with one or more embodiments of the present disclosure. The PIM 116 may generate various measurements of the input power 106 including, but not limited to, input voltages and input currents and may further calculate energy metering data thereof. For example, the PIM 116 may include PIM current sensing circuitry 202 and/or PIM voltage sensing circuitry 204. The PIM 116 may also include one or more PIM microcontrollers 206, a PIM power supply 208, and a PIM memory 210.

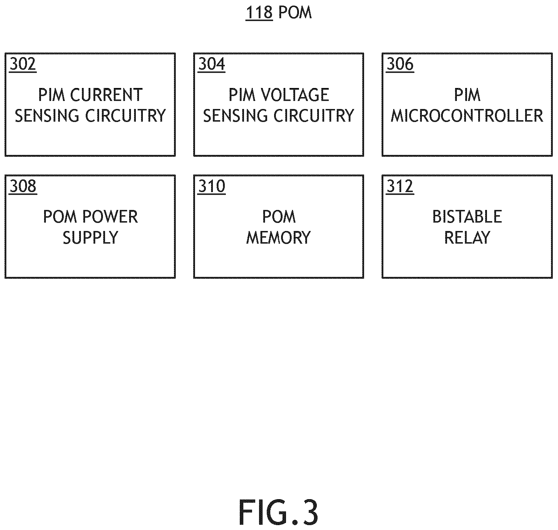

FIG. 3 is a block diagram view of a POM 118, in accordance with one or more embodiments of the present disclosure. The POM 118 may generate various measurements of power signals 102 associated with power transfer to the output loads 110 through the outlets 112 including, but not limited to, load voltages and load currents and may further calculate energy metering data thereof. For example, the POM 118 may include POM current sensing circuitry 302 and/or POM voltage sensing circuitry 304. The POM 118 may also include one or more POM microcontrollers 306, a POM power supply 308, and a POM memory 310. The POM 118 may further control bistable relays 312 to selectively provide power (or not provide power) to each of the outlets 112.

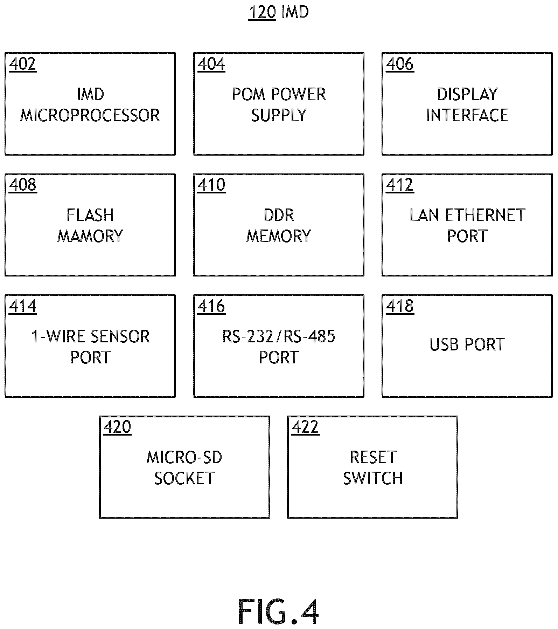

FIG. 4 is a block diagram view of an IMD 120, in accordance with one or more embodiments of the present disclosure. The IMD 120 may include, but is not limited to, one or more IMD microcontrollers 402, an IMD power supply 404, a display interface 406, or a non-volatile (NV) memory in the form of flash memory 408 and/or DDR memory 410. The IMD 120 may also include a plurality of ports including, but not limited to, one or more LAN Ethernet ports 412, one or more 1-wire sensor ports 414, an RS-232/RS-485 port 416, a USB port 418, or a microSD socket 420. The IMD may be coupled to a reset switch 422 for enabling a user to initiate a hard reset to the IMD 120, the power system 100 and/or other subsystems within the power system 100. The IMD 120 may also communicate with other componentry via an RS-485 physical layer. In some embodiments, the IMD 120 is provided as a hot-swappable web card in the power system 100.

The IMD 120 may serve as the monitoring host controller for the power system 100, and may be in constant communication with the POM 118. By communicating with the POM 118, the IMD 120 may provide a means for a user to enable or disable one or more features of the power system 100, as well as acquire and display status information. In embodiments, the IMD 120 does not directly sense the receptacle voltage and/or execute connection or disconnection algorithms, but rather may direct such actions to be executed by one or more POMs 118.

In embodiments, the IMD 120, the PIM 116, and/or the POM 118 are communicatively coupled (e.g., via one or mere communication busses). In this way, each may command, send data to, and/or receive data from any of the others. For example, the IMD 120 may command the PIM 116, which may in turn command the POM 118 to configure the relay state of one or more of the bistable relays 312. As another example, the IMD 120 may act as a bus master, connected to both the PIM 116 and the POM 118, with the PIM 116 and the POM 118 not directly interacting with each other. As another example, the PIM 116 and/or the POM 118 are capable of autonomous communication and/or measurements without commands from the IMD 120. Such a configuration may be, but is not required to be, implemented using a multi-master bus.

Referring generally to FIGS. 1-4, it is to be understood that FIGS. 1-4 and the associated descriptions are provided merely for illustrative purposes and should not be interpreted as limiting. For example, the although FIG. 1 presents an IMD 120, a POM 118, and a PIM 116 as separately defined components of the power system 100, this is merely an illustration and should not be interpreted to limit the scope of the present disclosure. In some embodiments, any of the IMD 120, the POM 118, and the PIM 116 may be integrated together in a common housing or as a common component. Further, the IMD 120, the POM 118, and/or the PIM 116 may generally include any type of processors known in the art including, but not limited to, a microprocessor, a microcontroller, a field-programmable gate array (FPGA), an application-specific integrated circuit (ASIC), a digital signal processor (DSP), a central processing unit (CPU), or a graphical processing unit (GPU). The IMD 120, the POM 118, and/or the PIM 116 may also include any type of memory (e.g., a non-transitory medium) including, but not limited to, a read-only memory, a random-access memory, a solid-state drive, or the like. Some embodiments of a power system 100 are generally described in United States Patent Application Serial Number 18/198,504 entitled "OUTLET IN-RUSH CURRENT LIMITER FOR INTELLIGENT POWER STRIP" filed on May 17, 2023 by Kevin Ferguson, Casey Gilson, Scott Cooper, and Jason Armstrong, which is incorporated by reference in its entirety. As another example, the power system 100 may have any combination of controllers and does not require a PIM 116, a POM 118, or an IMD 120 as depicted in FIGS. 1-4.

As a result, any of the IMD 120, the one or more PIMs 116, the one or more POMs 118, or any combination of controllers more generally may execute program instructions (or subsets of program instructions) alone or in combination to implement various process steps disclosed herein.

For example, a PIM 116 and/or a POM 118 may generate or receive power signals 102, generate DWT coefficients associated with the power signals 102, and/or classify of the power signals 102 based on the DWT coefficients. Each PIM 116 and/or POM 118 POM 118 may then send any such data to the IMD 120 for further processing and/or communication with external systems (e.g., servers, other power systems 100 (PDUs), or the like). For example, the IMD 120 may manage and collect data from multiple PIMs 116 and/or POMs 118 and/or direct actions based on the data. As another example, the IMD 120 may receive user commands and/or instructions and may direct components such as the PIM 116 or the POMs 118 in compliance with such instructions. As another example, the IMD 120 may provide PIMs 116 and/or POMs 118 with instructions and/or executable operations suitable for classifying power signals 102 based on DWT coefficients. For instance, the IMD 120 may train a machine learning model based on power signals 102 from any source and then provide the trained machine learning model to any number of PIMs 116 and/or POMs 118 for implementation. In another instance, the IMD 120 may determine suitable thresholds for classifying power signals 102 based on comparing DWT coefficients to reference DWT coefficients using selected metrics and then provide these thresholds or other instructions to any number of PIMs 116 and/or POMs 118 for implementation.

In some embodiments, various process steps, combinations of process steps, or portions of process steps are distributed between different components of the power system 100. Such a configuration may provide efficient use of computational resources and/or minimize cost.

For example, a PIM 116 and/or a POM 118 may have relatively simpler architecture than the IMD 120. As an illustration, a PIM 116 and/or a POM 118 may include microcontrollers and/or math accelerators suitable for receiving data and performing computational tasks on the data. The IMD 120 may then include more advanced processing units such as, but not limited to, a microprocessor, a DSP, a GPU, a faster CPU, or the like. In this way, the IMD 120 may perform more computationally intensive tasks, interface with a user, interface with additional equipment, or the like.

Further, in some embodiments, one or more controllers configured to execute various process steps disclosed herein such as, but not limited to, training a machine learning model or classifying power signals 102 with a trained machine learning model may be provided as standalone components. For example, such controllers (e.g., controllers providing at least some of the functionality of an IMD 120, one or more PIMs 116, and/or the one or more POMs 118 as described with respect to FIGS. 1-4) may be separate from but may integrate with circuitry used to monitor power signals 102 and/or distribute power to any selected outlets 112.

FIG. 5 is a flow diagram illustrating steps performed in a method 500 for classifying monitored devices 122, in accordance with one or more embodiments of the present disclosure. The embodiments and enabling technologies described previously herein in the context of the power system 100 should be interpreted to extend to the method 500. For example, an IMD 120, a PIM 116, and/or a POM 118 may execute program instructions causing associated processors to implement any of the process steps of the method 500 or portions thereof individually or in combination. It is further noted, however, that the method 500 is not limited to the architecture of the power system 100. In this way, the various process steps of the method 500 may be implemented using any number or type of components.

In embodiments, the method 500 includes a process step 502 of capturing power signals 102 for any monitored devices 122. For example, the power signals 102 may include a current or a voltage of a power signal 102 provided to a respective monitored device 122. As an illustration in the context of the power system 100 in FIGS. 1-4, one or more PIMs 116 and/or POMs 118 may capture the power signals 102 via associated sensing circuitry, though this is merely an illustration. As another example, root mean square (RMS) measurements of the power signals 102 may be captured.

In embodiments, the method 500 includes a process step 504 of performing DWTs of the power signals 102 to generate DWT coefficients. The DWT coefficients may be generated using any type of wavelet known in the art including, but not limited to, a Haar wavelet, a Morlet wavelet, a Mexican hat wavelet, a biorthogonal wavelet, a spline wavelet, or a Daubechies wavelet. Further, the step 504 may provide any number of DWT coefficients. For example, a typical DWT process may generate the same number of coefficients as samples in an input signal (e.g., a number of samples of the associated power signals 102).

The step 504 may further include pre-processing the DWT coefficients. For example, the step 504 may include normalizing the DWT coefficients using any suitable technique including, but not limited to, a z-score normalization. As another example, the step 504 may include removing outliers from the DWT coefficients. For instance, DWT coefficients may be filtered and/or binned either using absolute thresholds or relative thresholds (e.g., based on z-score normalization, or the like). It is contemplated herein that removing outliers from DWT coefficients may improve robustness and avoid improper classification based on spurious signals.

In embodiments, the method 500 includes a process step 506 of classifying the power signals 102 into two or more classes based on the corresponding DWT coefficients. For example, the two or more classes include one or more normal classes associated with one or more acceptable operational condition and one or more atypical classes associated with one or more atypical operational conditions.

In some embodiments, power signals 102 are classified using a binary-class classification system including a single normal class and a single atypical class. Such a configuration may be well suited for, but not limited to, characterizing power signals 102 of a single type, where an alert of atypical behavior is desired. In some embodiments, power signals 102 are classified using a multi-class classification system including a single normal class and multiple atypical classes. Such a configuration may be well suited for, but not limited to, characterizing power signals 102 of a single type, where discrimination between different atypical classes is desired. For instance, different atypical classes may be associated with different failure mechanisms and/or different pre-failure conditions.

Binary-class classification and/or multi-class classification as disclosed herein may be suitable for detecting a wide range of operational states. Some non-limiting examples include detecting electrical equipment earth leakage through changes of load-profile, identifying early indications of transistor breakdown (e.g., insulated-gate bipolar transistor (IGBT) breakdown, or the like), using load-profile changes to identify abnormal thermal conditions, providing data to enable condition-based preventative maintenance services, or as a means of implementing stand-alone (e.g., non-networked) equipment health monitoring applications.

In some embodiments, power signals 102 are further classified based on device type. It is contemplated herein that such different device types may have different power signals 102 or signatures when operating in a normal condition and may further have different power signals 102 or signatures in any number of different fault or pre-fault conditions (e.g., associated with atypical classes).

The systems and methods may discriminate between any device types such as, but not limited to, power supplies (e.g., switching power supplies, linear power supplies, or the like used in servers, personal computers, storage systems, or any other devices), HVAC (heating, ventilation, and air conditioning) systems, UPS (uninterruptable power supplies), lighting fixtures, or electrical machines. The systems and methods may further discriminate between any combination of AC powered devices or DC powered devices. For instance, in the case of a DC device, power signals may be associated with periodic sampling and/or may be synchronized to run at the onset of a transient signal.

Accordingly, different normal and/or atypical conditions may be defined for the different classes. Further, the device type may be known or unknown during classification. For example, when the device type of a particular monitored device 122 is known, this information may be used to limit the available classes used when classifying the associated. However, when the device type of a particular monitored device 122 is unknown, systems and methods disclosed herein may both identify the device type and classify its operational status.

In some embodiments, the step 506 of classifying the power signals 102 into two or more classes based on the corresponding DWT coefficients includes comparing the DWT coefficients of measured monitored devices 122 to one or more sets of reference DWT coefficients using one or more metrics. Any suitable metric or combination of metrics may be used. For example, the PCC may measure a strength of association between DWT coefficients associated with a measured power signal 102 and reference DWT coefficients, where a PCC value of -1 corresponds to lowest correlation and a PCC value of +1 corresponds to highest correlation. As another example, the NRMSE may measure differences or error between DWT coefficients associated with a measured power signal 102 and reference DWT coefficients in a manner that is not scale invariant.

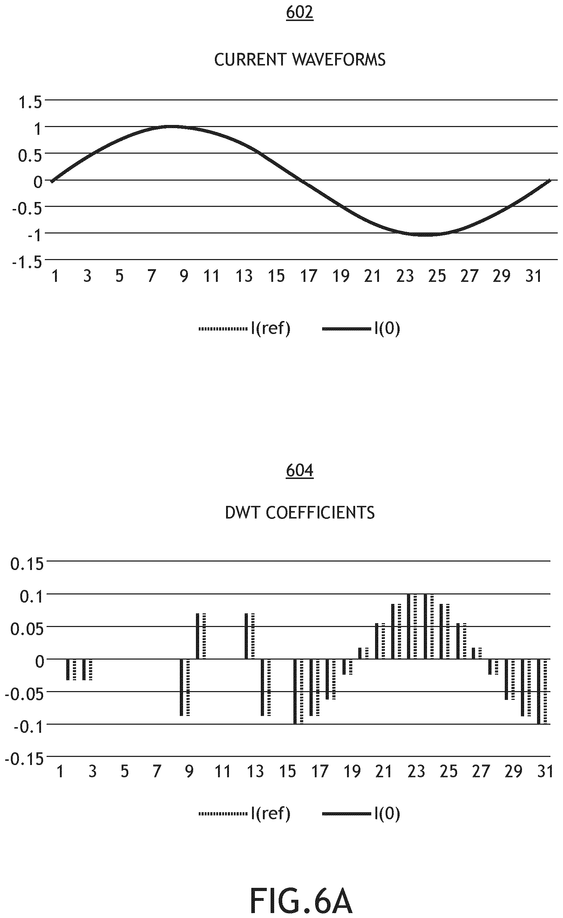

It is contemplated herein that different metrics may provide different measures of similarity and that certain differences between DWT coefficients of a particular power signal 102 and reference DWT coefficients may be more clearly determined through different metrics. FIGS. 6A-6G depict comparisons of power signals 102 (particularly current waveforms) and reference signals, along with the corresponding DWT coefficients, PCC values, and NRMSE values for a variety of signal patterns. It is noted that FIGS. 6A-6G depict only a single period of the associated patterns, but this is merely an illustration and not limiting on the scope of the present disclosure.

FIG. 6A includes a time-scale plot 602 and a plot 604 of DWT coefficients for a power signal 102 ($I$(0)) and a reference signal ($I$(ref)), where the reference signal is identical to the power signal 102, in accordance with one or more embodiments of the present disclosure. In this case, the power signal 102 the power signal 102 and the reference signal are equivalent and expressed as $I = A \sin \omega_1$. As a result, they overlap in time and have equivalent DWT coefficients.

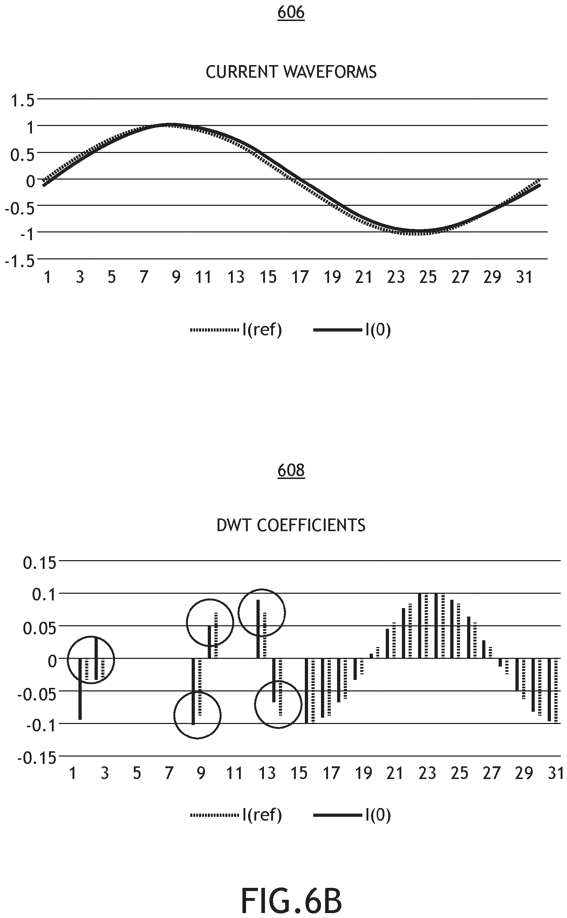

FIG. 6B includes a time-scale plot 606 and a plot 608 of DWT coefficients for a power signal 102 ($I(0)$) and a reference signal $(I(ref))$, where the reference signal is phase shifted relative to the power signal 102 by five degrees, in accordance with one or more embodiments of the present disclosure. The reference signal is expressed as $I_{ref} = A \sin(\omega_1 + \phi_{5°})$. As shown in plot 608, the phase shift results in a modification of a portion of the DWT coefficients, which are circled in the figure. The NRMSE is 8.93% and the PCC is +0.955. In this case, the PCC indicates a high degree of similarity, while the NRMSE indicates a relatively moderate degree of similarity.

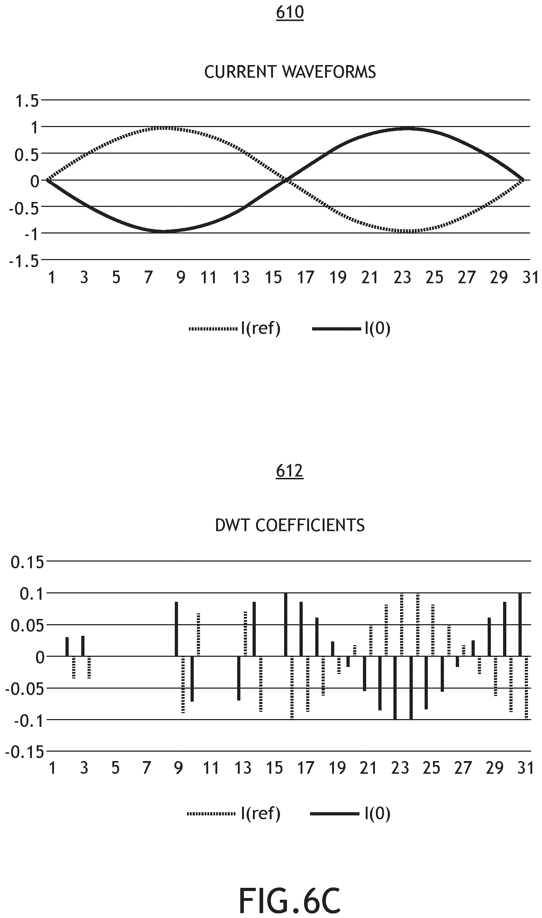

FIG. 6C includes a time-scale plot 610 and a plot 612 of DWT coefficients for a power signal 102 ($I(0)$) and a reference signal $(I(ref))$, where the reference signal is phase shifted relative to the power signal 102 by 180 degrees, in accordance with one or more embodiments of the present disclosure. The reference signal is expressed as $I_{ref} = A \sin((\omega_1 + \phi_{180°})$. As shown in plot 612, the 180-degree phase shift flips the signs of the DWT coefficients. The NRMSE is 60.14% and the PCC is -1. Notably, both the PCC and NRMSE interpret these signals as completely dissimilar.

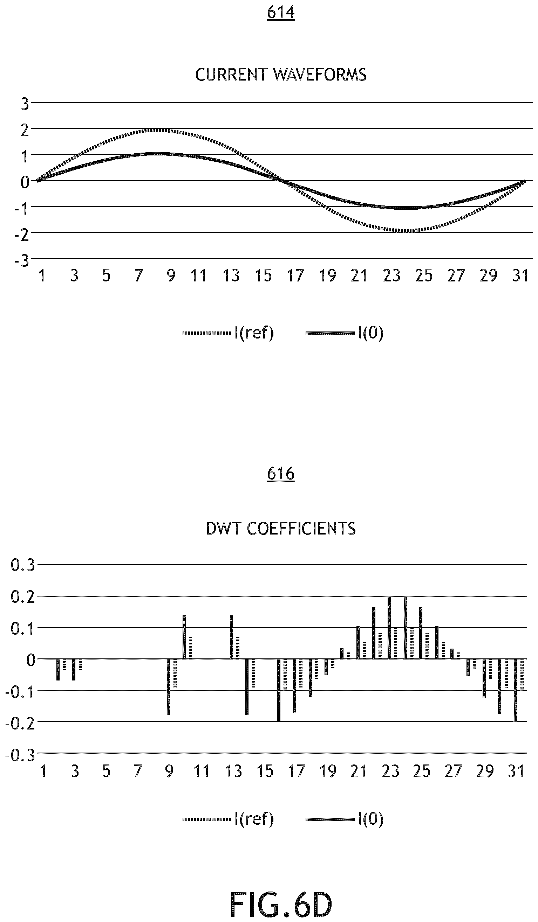

FIG. 6D includes a time-scale plot 614 and a plot 616 of DWT coefficients for a power signal 102 ($I(0)$) and a reference signal $(I(ref))$, where the reference signal has half the amplitude of the power signal 102, in accordance with one or more embodiments of the present disclosure. The reference signal is expressed as
$$I_{ref} = \frac{A}{2}\sin(\omega_1)$$
. As shown in plot 616, the amplitude modification changes the absolute amplitude of the DWT coefficients but not the relative amplitudes. The NRMSE in this case is 15.04% and the PCC is +1. Notably, the PCC views these DWT coefficients as identical due to the scale invariance of the PCC, whereas the NRMSE does not provide scale invariance and detects a high degree of dissimilarity.

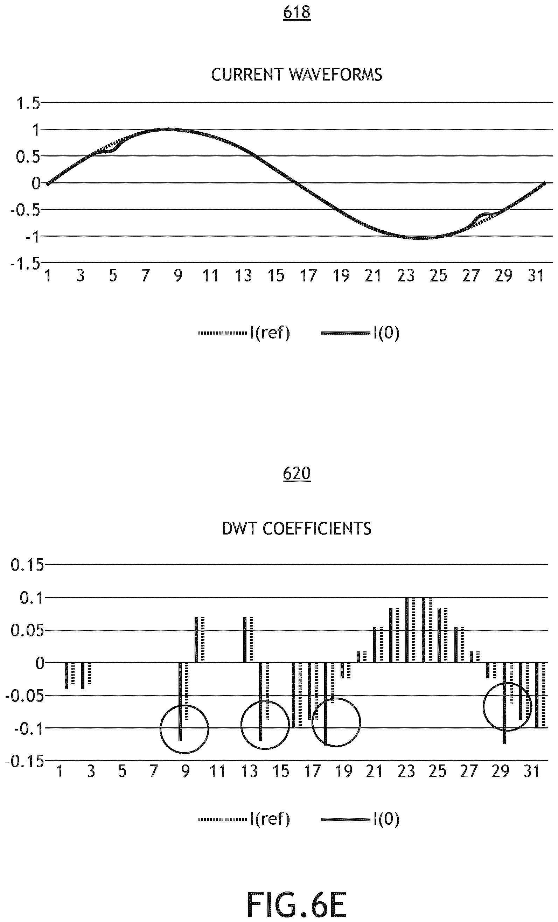

FIG. 6E includes a time-scale plot 618 and a plot 620 of DWT coefficients for a power signal 102 ($I(0)$) and a reference signal $(I(ref))$, where the reference signal has two temporal and spatial anomalies, in accordance with one or more embodiments of the present disclosure. As shown in plot 620, the temporal and spatial anomalies produce measurable changes in certain DWT coefficients, which are circled in the figure. The NRMSE in this case is 7.98% and the PCC is +0.975. Notably, the PCC indicates a relatively high degree of similarity, while the NRMSE indicates a moderate degree of similarity.

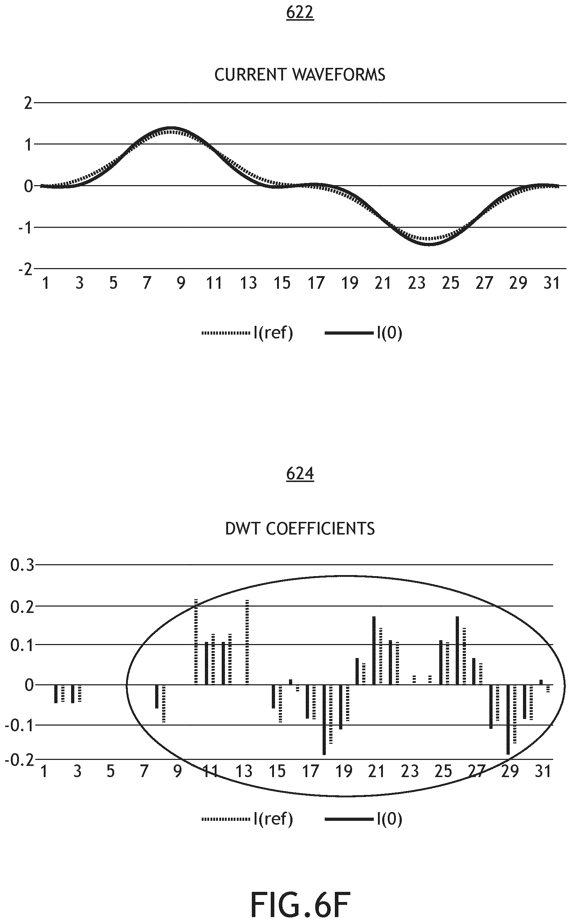

FIG. 6F includes a time-scale plot 622 and a plot 624 of DWT coefficients for a power signal 102 ($I(0)$) and a reference signal $(I(ref))$, where both signals are a combination of a fundamental and a third harmonic signal, but where the reference signal is a different amplitude of the third harmonic signal, in accordance with one or more embodiments of the present disclosure. The reference signal is expressed as $I_{ref} = A \sin(\omega_1) + 1.3 \sin(\omega_3)$. As shown in plot 624, the DWT coefficients differ in both pattern and amplitude. The NRMSE in this case is 16.54% and the PCC is +0.814, indicating that both metrics identify the differences reasonably well.

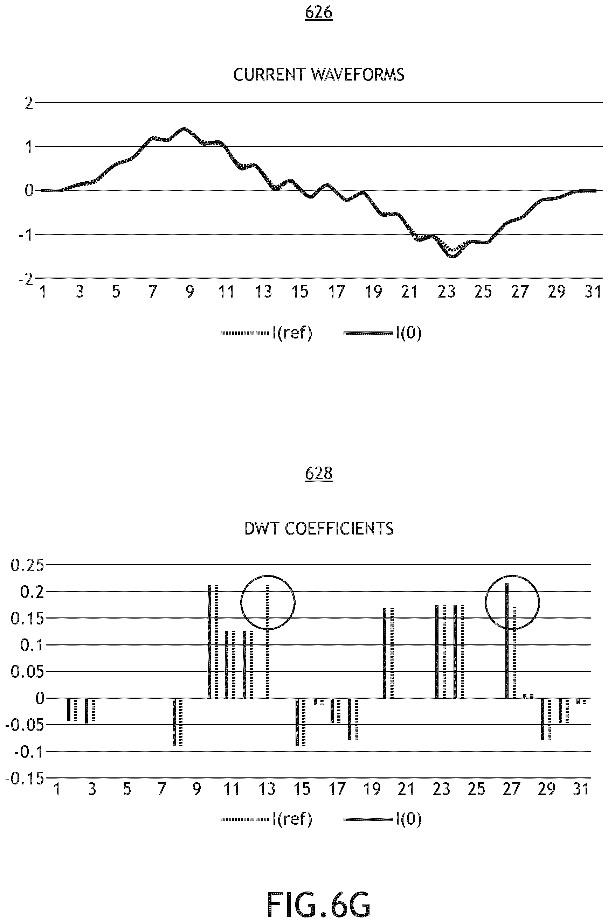

FIG. 6G includes a time-scale plot 626 and a plot 628 of DWT coefficients for a power signal 102 ($I(0)$) and a reference signal $(I(ref))$, where both signals are a combination of a fundamental and a high-order 32-harmonic signal, but where the reference signal includes a spatial anomaly. As shown in plot 628, two of the DWT coefficients differ between the signals. The NRMSE in this case is 12.68% and the PCC is +0.906, indicating that both metrics identify the differences reasonably well.

Referring generally to FIGS. 6A-6G, FIGS. 6A-6G provide non-limiting examples illustrating the effectiveness of DWT techniques to extract minute features from the raw power signals 102. Further, depending upon the spatial and temporal differences, different metrics (e.g., the PCC and NRMSE depicted here) may be sensitive to different types of signal variations. As a result, it may be beneficial to utilize multiple metrics in step 506 to robustly identify a wide range of differences between DWT coefficients associated with power signals 102 and those of reference signals.

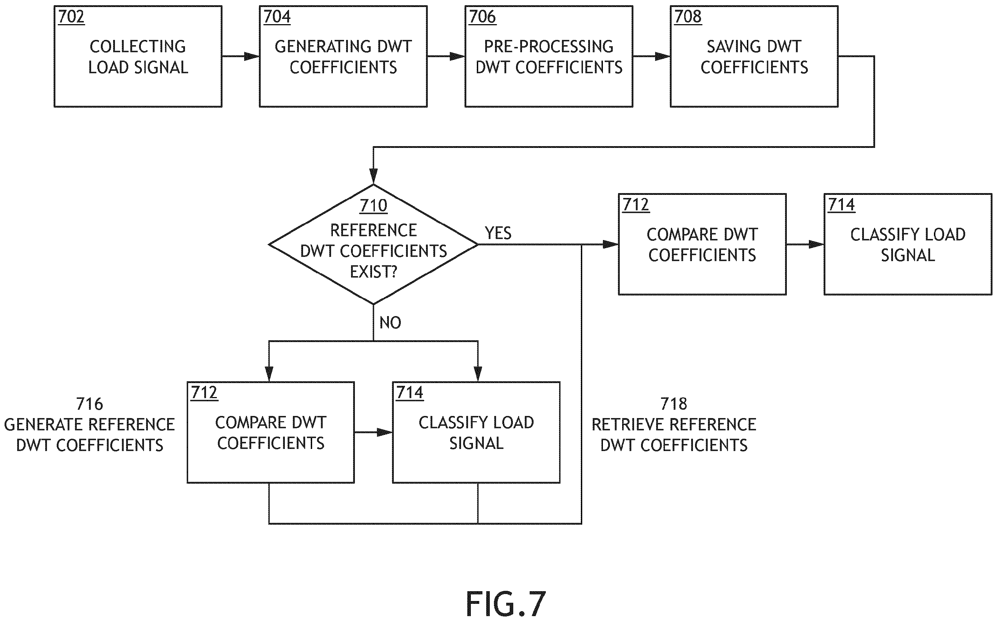

Referring now to FIG. 7, FIG. 7 is a flow diagram depicting classification of a power signal 102 based on comparing associated DWT coefficients to reference coefficients is described in greater detail, in accordance with one or more embodiments of the present disclosure.

FIG. 7 depicts collecting the power signal 102 (block 702) and generating associated DWT coefficients (block 704). FIG. 7 further depicts pre-processing the DWT coefficients (block 706) and saving the DWT coefficients to memory (block 708). For example, the pre-processing may include normalization, filtering, and/or binning as described previously herein.

If reference DWT coefficients exist (decision block 710), one or more metrics may be used to compare the DWT coefficients of the captured power signal 102 to the reference DWT coefficients (block 712). Finally, the power signal 102 may be classified (block 714) based on the values of the metrics.

In the case where multiple metrics are used for the classification, the outputs of the multiple metrics may be combined using any suitable technique. For example, classes may be defined based on selected thresholds and/or ranges of values provided by the metrics.

If reference DWT coefficients do not yet exist (decision block 710), reference DWT coefficients may be generated (block 716) or retrieved (block 718). For example, reference DWT coefficients may be defined (block 718) to be the current set of DWT coefficients for the current power signal 102 or by DWT coefficients associated with a dedicated measurement of power signals 102 over a selected timeframe. As another example, the reference DWT coefficients may be retrieved (block 718) from any suitable source. For instance, the IMD 120 may retrieve reference DWT coefficients from a memory or from an external source such as, but not limited to, a data lake (e.g., one or more servers) and then provide the reference DWT coefficients to a PIM 116.

It is contemplated herein that power signals 102 may be classified into any number of classes based on comparison of DWT coefficients from measured power signals 102 to reference DWT coefficients. In embodiments, at least one of the available classes corresponds to a normal class, which may be associated with power signals 102 having acceptable parameters for a particular application. Further, at least one of the available classes corresponds to an atypical class, which may be associated with power signals 102 in a failure condition or pre-failure condition.

For example, binary-class classification may be performed using a single set of reference DWT coefficients.

As another example, two or more sets of reference DWT coefficients may be generated, where each set corresponds to a different failure condition or pre-failure condition of a corresponding monitored device 122. In this configuration, a power signal 102 may be classified based on which set of reference DWT coefficients is most similar to the DWT coefficients of the measured power signal 102 based on the metrics.

Further, various techniques may be used when different device types are considered. When the device type of a particular monitored device 122 is known, one or more corresponding sets of reference DWT coefficients may be used for the comparison. When the device type of a particular monitored device 122 is not known, the DWT coefficients associated with a measured power signal 102 may be compared to any number of reference DWT coefficients to determine both the device type and the operational condition.

As another example, two or more sets of reference DWT coefficients may be generated, where each set corresponds to a different failure condition or pre-failure condition of a corresponding monitored device 122. In this configuration, a power signal 102 may be classified based on which set of reference DWT coefficients is most similar to the DWT coefficients of the measured power signal 102 based on the metrics.

Referring again to FIG. 5, in some embodiments, the step 506 of classifying the power signals 102 into two or more classes based on the corresponding DWT coefficients includes classifying the power signals 102 into two or more classes based on the corresponding DWT coefficients using a machine learning model that accepts the corresponding DWT coefficients as inputs. More generally, the machine learning model may be developed or trained to classify power signals 102 based upon associated DWT coefficients and any other associated signals such as, but not limited to, RMS data associated with the monitored devices 122. In this way, the machine learning model may utilize a wide range of inputs that include, but are not limited to, DWT coefficients of power signals 102 for classification.

The machine learning model may utilize any type of learning or combination of learning types including, but not limited to, supervised learning, unsupervised learning, or reinforcement learning. Further, any type of machine learning model known in the art may be utilized in step 506 such as, but not limited to, a support vector machine model, a nearest neighbor model, a perceptron, a logistic regression model, or a Bayes model.

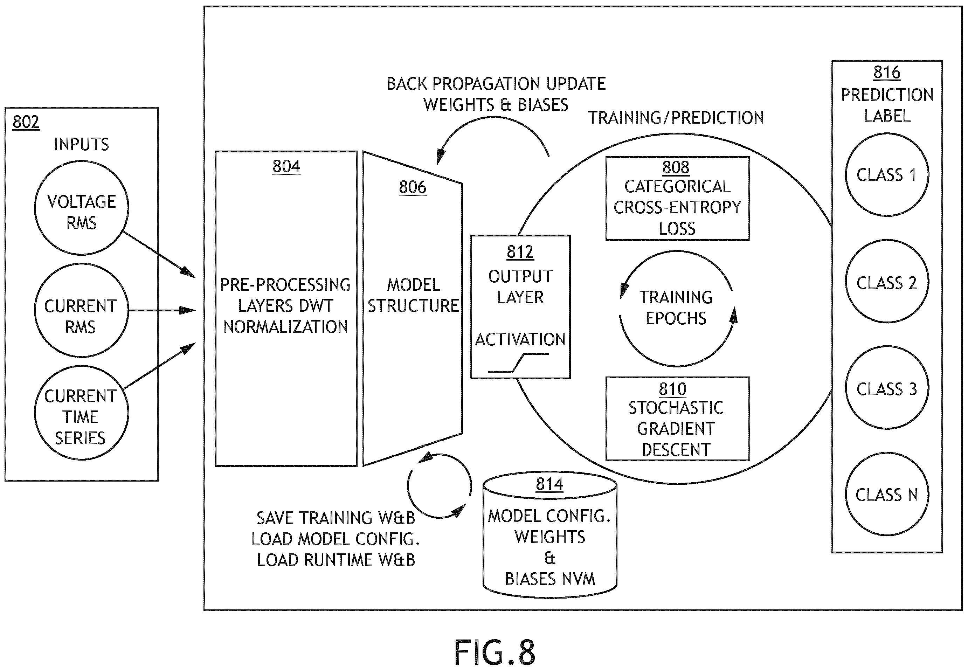

FIG. 8 is a flow diagram depicting classification using a machine learning model, in accordance with one or more embodiments of the present disclosure. FIG. 8 depicts a particular configuration with a convolutional neural network (CNN) trained through supervised learning, though it is to be understood that this is merely an illustration and not a limitation on the type or structure of a machine learning model.

As depicted in FIG. 8, various inputs 802 may be pre-processed (block 804) into a form suitable for use with a machine learning model structure 806. For example, the machine learning model structure 806 may include, but is not limited to, a multi-layer perceptron (MLP), a convolutional neural network (CNN), or the like.

The pre-processing may include generating DWT coefficients from a time-series power signal 102 and optionally normalizing, filtering, and/or binning the DWT coefficients as described previously herein. As another example, the pre-processing may incorporate additional inputs 802 such as, but not limited to voltage RMS values or current RMS values associated with the power signal 102 into a common format for input to the machine learning model structure 806 (e.g., a tensor, or the like). In this way, the machine learning model structure 806 may implement a classification based on any number or type of inputs and is not limited to power signals 102.

The machine learning model structure 806 may then be trained using any number of training epochs using any suitable loss function 808, optimization function 810, and activation function 812. Any suitable loss function 808 may be utilized such as, but not limited to, a binary cross-entropy loss function or a hinge loss function. Any suitable optimization function 810 may be utilized such as, but not limited to, a gradient descent function (e.g., a stochastic gradient descent function, or the like). Any suitable activation function 812 may be utilized such as, but not limited to, a tanh for hidden layers, a sigmoid function (e.g., for binary-class classification) or a softmax function (e.g., for multi-class classification) for an output layer. The model configurations, weights, and biases may be stored in memory 814 and updated through the training process.

Training data may generally include DWT coefficients and/or any additional input data associated with known classes (e.g., labeled input data). The training data may further be provided through any source. For example, training data may be synthetically generated either locally or remotely. As another example, training data may be associated with historical power signals 102 with known classes, which may be generated locally or received from a remote source (e.g., a data lake, or the like).

Once trained, the machine learning model structure 806 may be used to classify an input power signal 102 into one of any number of classes 816 (e.g., assign output labels to an input power signal 102). In some embodiments, the machine learning model structure 806 provides a probability that a particular power signal 102 belongs to each class. In this way, the class having the highest probability may correspond to the assigned class. In some cases, the probabilities that a particular power signal 102 belongs to various classes are used to generate a confidence or uncertainty metric associated with the classification. In some cases, an additional class may be defined that is associated with uncertain results. For instance, a particular power signal 102 may be assigned to such an uncertain class if probabilities associated with multiple classes are sufficiently close (e.g., a difference between the probabilities is below a selected threshold) and/or if the highest probability is lower than a selected threshold).

It is noted FIG. 8 depicts a non-limiting configuration implementing multi-class classification and should not be interpreted as limiting on the scope of the present disclosure. In particular, FIG. 8 depicts classification of power signals 102 into N classes 816 (e.g., prediction labels). Further, FIG. 8 depicts classification based on multiple inputs 802 including power signals 102 (e.g., digitized versions of power signals 102) as well as RMS current and voltage values associated with the power signals 102. However, any number or combination of inputs 802, number classes 816, and/or type of classes 816, are within the spirit and scope of the present disclosure.

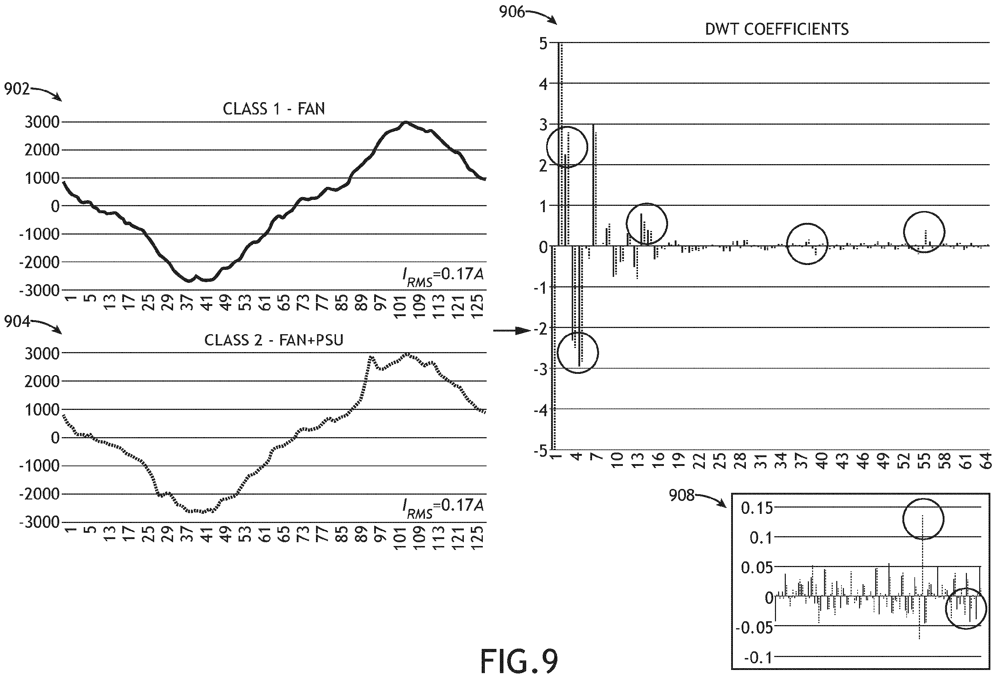

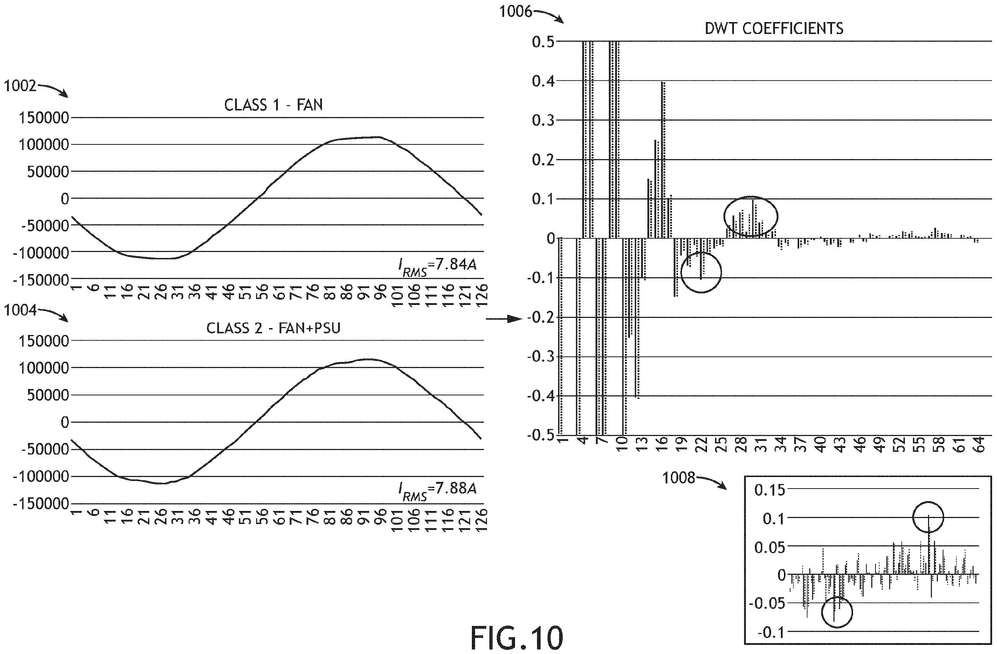

FIGS. 9-10 depict illustrations of classifying power signals 102 associated with a fan and varying additional components with a machine learning model, in accordance with one or more embodiments of the present disclosure. FIG. 9 includes a plot 902 of a power signal 102 of a fan, a plot 904 of the fan plus a power supply unit (PSU), along with a zoomed plot 906 and an expanded plot 908 of the associated DWT coefficients, in accordance with one or more embodiments of the present disclosure. The circles in the figure indicate variations in the DWT coefficients between the two cases. Similarly, FIG. 10 includes a plot 1002 of a power signal 102 of a fan plus a heater, a plot 1004 of the fan, the heater, and a rack power distribution unit (RPDU), along with a zoomed plot 1006 and an expanded plot 1008 of the associated DWT coefficients, in accordance with one or more embodiments of the present disclosure. Although not explicitly shown, a multi-class classification model trained in a manner depicted in FIG. 8 successfully distinguished the power signals 102 associated with the four classes and thus provided device type classification based on the associated DWT coefficients.

It is further contemplated herein that practical implementation of a machine learning model such as, but not limited to, that depicted in FIG. 8 may be computationally intensive. As a result, it may be desirable to distribute various tasks between different computational elements to balance throughput and system cost.

In some embodiments, a power system 100 as depicted in FIGS. 1-4 may distribute various implementation aspects between the IMD 120 and one or more POMs 118.

For example, the IMD 120 may perform the computationally intensive task of training a machine learning model and then send the trained model to PIMs 116 and/or POMs 118 for implementation. As an illustration, the IMD 120 may compute weights and biases, activation per layer for forward propagation, and optimization/loss for back propagation. This data, along with the structure of the machine learning model may then be sent to a PIM 116 and/or a POM 118. Each PIM 116 and/or POM 118 may generate or receive power signals 102, perform pre-processing of the power signals 102, generate DWT coefficients associated with the power signals 102, and/or classify of the power signals 102 based on the DWT coefficients using the trained machine learning model.

As another example, the IMD 120 may receive a trained machine learning model and then send the trained model to the PIMs 116 and/or POMs 118. In this way, the machine learning model may be trained by an external system, which may substantially reduce computational requirements of the power system 100.

The IMD 120 may further provide additional tasks such as, but not limited to, logging, communication to external sources (e.g., a data lake) for training and/or archival purposes, or commanding the PIMs 116 and/or POMs 118 (or other components) to capture power signals 102 at selected times for training and/or classification, or selecting a particular machine learning model for implementation (e.g., selecting a binary-class classification model, a multi-class classification model, or the like).

Referring again to FIG. 5, the method 500 may further include a process step 508 of generating one or more alert signals based on the classified power signals 102 when one or more alert conditions are met. Any alert condition may be utilized. For example, an alert condition may include classification of a power signal 102 into one of the one or more atypical conditions. As another example, an alert condition may include classification of a power signal 102 as an unexpected device type. For instance, a device type may be provided by a user or an external system such that classification of a monitored device 122 as a different device type may trigger an alert.

The alert signals may further trigger any action. For example, an alert signal may trigger the automatic disconnection of an associated monitored device 122. As another example, the alert signal may trigger at least one of a visual indicator (e.g., via one or more visual display devices 124 or an audio indicator (e.g., via one or more speakers 126). In this way, any combination of visual or audio text, speech, graphics, or other indicators may be provided to a user. As an illustration, alert signals may trigger visual and/or audio indications that one or more monitored devices 122 may need to be disconnected, repaired, receive maintenance, or are classified as a different device type than expected. As another example, the alert signal may trigger a remote indicator using any selected protocol such as, but not limited to, email, simple network management protocol (SNMP), modbus, or an application programming interface (API) of a selected service.

The herein described subject matter sometimes illustrates different components contained within, or connected with, other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "connected" or "coupled" to each other to achieve the desired functionality, and any two components capable of being so associated can also be viewed as being "couplable" to each other to achieve the desired functionality. Specific examples of couplable include but are not limited to physically interactable and/or physically interacting components and/or wirelessly interactable and/or wirelessly interacting components and/or logically interactable and/or logically interacting components.

It is believed that the present disclosure and many of its attendant advantages will be understood by the foregoing description, and it will be apparent that various changes may be made in the form, construction, and arrangement of the components without departing from the disclosed subject matter or without sacrificing all of its material advantages. The form described is merely explanatory, and it is the intention of the following claims to encompass and include such changes. Furthermore, it is to be understood that the invention is defined by the appended claims.

The disclosure comprises the following items:

1. A power system comprising:
one or more controllers including one or more processors configured to execute program instructions stored on one or more memory devices, wherein the program instructions are configured to cause the one or more processors of the one or more controllers to:

receive power signals for one or more monitored devices, wherein a respective power signal includes at least one of a current or a voltage;
perform discrete wavelet transforms (DWTs) of the power signals to generate DWT coefficients associated with the power signals;
classify the power signals within two or more classes based on the DWT coefficients, wherein the two or more classes include one or more normal classes associated with one or more acceptable operational conditions and one or more atypical classes associated with one or more atypical operational conditions; and
generate one or more alert signals based on the classified power signals when one or more alert conditions are met.

2. The power system of item 1, further comprising:
at least one of current or voltage sensing circuitry to generate the power signals for at least one of the one or more monitored devices.

3. The power system of item 1 or item 2, wherein the power signal for at least one of the one or more monitored devices is received from in-line monitoring circuitry.

4. The power system of any preceding item, wherein the power signals correspond to signals between one or more output loads and one or more outlets of a power distribution sub-system including circuitry to distribute input power to the one or more outlets, wherein the one or more monitored devices comprise the one or more output loads, wherein the one or more controllers comprise:

one or more power output modules (POMs) configured to be communicatively coupled to the one or more outlets, wherein the one or more POMs are configured to receive the power signals, perform the DWTs of the power signals to generate the DWT coefficients associated with the power signals, and classify the power signals within the two or more classes based on the DWT coefficients; and
an interchangeable monitoring device (IMD) configured to be communicatively coupled with the one or more POMs, wherein the IMD is configured to generate the one or more alert signals based on the classified power signals when the one or more alert conditions are met.

5. The power system of any preceding item, wherein the power signals correspond to signals from an input source, wherein the one or more monitored devices comprise the input source, wherein the one or more controllers comprise:

one or more power input modules (PIMs) configured to receive the power signals, perform the DWTs of the power signals to generate the DWT coefficients associated with the power signals, and classify the power signals within the two or more classes based on the DWT coefficients; and
an interchangeable monitoring device (IMD) configured to be communicatively coupled with the one or more PIMs, wherein the IMD is configured to generate the one or more alert signals based on the classified power signals when the one or more alert conditions are met.

6. The power system of any preceding item, wherein the two or more classes comprise a binary set of classes, wherein the one or more normal classes include a single normal class, wherein the one or more atypical classes include a single atypical class.

7. The power system of any preceding item, wherein the two or more classes comprise:
two or more sets of classes, wherein each of the two or more sets of classes corresponds to a different one of one or more device types, wherein each of the two or more sets of classes includes at least one of the one or more normal classes and at least one of the one or more atypical classes.

8. The power system of any preceding item, wherein the one or more alert conditions include classification of at least one of the power signals into a class associated with a different one of the one or more device types than an expected device type.

9. The power system of any preceding item, wherein the one or more alert conditions include classification of at least one of the power signals into one of the one or more atypical classes.

10. The power system of any preceding item, wherein classifying the power signals within the two or more classes based on the DWT coefficients comprises:
classifying the power signals within the two or more classes based on the DWT coefficients by comparing the DWT coefficients to reference DWT coefficients using one or more metrics.

11. The power system of any preceding item, wherein the one or more metrics comprise:
at least one of a Pearson's correlation coefficient or a normalized root mean-square error.

12. The power system of any preceding item, wherein the reference DWT coefficients are generated based on one or more of the power signals from one or more of the monitored devices in a normal condition.

13. The power system of any preceding item, wherein classifying the power signals within the two or more classes based on the DWT coefficients comprises:
classifying the power signals within the two or more classes based on the DWT coefficients using a machine learning model that accepts the DWT coefficients as inputs.

14. The power system of any preceding item, wherein the machine learning model is trained on training data including at least one of labeled DWT coefficients associated with the two or more classes or RMS data associated with the one or more monitoring devices.

15. The power system of any preceding item, wherein at least some of the labeled DWT coefficients associated with the two or more classes are associated with historical power signals generated by at least one of in-line monitoring circuitry or a data lake.

16. The power system of any preceding item, wherein the power signals correspond to signals between one or more output loads and one or more outlets of a power distribution sub-system including circuitry to distribute input power to the one or more outlets, wherein the one or more monitored devices comprise the one or more output loads, wherein the one or more controllers comprise:

one or more power output modules (POMs) configured to be communicatively coupled to the one or more outlets, wherein the one or more POMs are configured to receive the power signals, perform the DWTs of the power signals to generate the DWT coefficients associated with the power signals, and classify the power signals within the two or more classes based on the DWT coefficients; and
an interchangeable monitoring device (IMD) configured to be communicatively coupled with the one or more POMs, wherein the IMD is configured to generate the one or more alert signals based on the classified power signals when the one or more alert conditions are met.

17. The power system of any preceding item, wherein the power signals correspond to signals from an input source, wherein the one or more monitored devices comprise the input source, wherein the one or more controllers comprise:

one or more power input modules (PIMs) configured to receive the power signals, perform the DWTs of the power signals to generate the DWT coefficients associated with the power signals, and classify the power signals within the two or more classes based on the DWT coefficients; and

an interchangeable monitoring device (IMD) configured to be communicatively coupled with the one or more PIMs, wherein the IMD is configured to generate the one or more alert signals based on the classified power signals when the one or more alert conditions are met.

18. The power system of any preceding item, wherein at least one of the one or more alert signals triggers at least one of a visual indicator, an audio indicator, or a remote indicator.

19. The power system of any preceding item, wherein at least one of the one or more alert signals directs disconnection of power to at least one of the monitoring devices.

20. A power monitoring method comprising:

receiving power signals for one or more monitored devices, wherein a respective power signal includes at least one of a current or a voltage; performing discrete wavelet transforms (DWTs) of the power signals to generate DWT coefficients associated with the power signals; classifying the power signals within two or more classes based on the DWT coefficients, wherein the two or more classes include one or more normal classes associated with one or more acceptable operational conditions and one or more atypical classes associated with one or more atypical operational conditions; and generating one or more alert signals based on the classified power signals when one or more alert conditions are met.

**Claims**

1. A power system comprising:
one or more controllers including one or more processors configured to execute program instructions stored on one or more memory devices, wherein the program instructions are configured to cause the one or more processors of the one or more controllers to:

receive power signals for one or more monitored devices, wherein a respective power signal includes at least one of a current or a voltage; perform discrete wavelet transforms (DWTs) of the power signals to generate DWT coefficients associated with the power signals; classify the power signals within two or more classes based on the DWT coefficients, wherein the two or more classes include one or more normal classes associated with one or more acceptable operational conditions and one or more atypical classes associated with one or more atypical operational conditions; and generate one or more alert signals based on the classified power signals when one or more alert conditions are met.

2. The power system of claim 1, further comprising: at least one of current or voltage sensing circuitry to generate the power signals for at least one of the one or more monitored devices.

3. The power system of claim 1 or claim 2, wherein the power signal for at least one of the one or more monitored devices is received from in-line monitoring circuitry.

4. The power system of any preceding claim, wherein the power signals correspond to signals between one or more output loads and one or more outlets of a power distribution sub-system including circuitry to distribute input power to the one or more outlets, wherein the one or more monitored devices comprise the one or more output loads, wherein the one or more controllers comprise:

one or more power output modules (POMs) configured to be communicatively coupled to the one or more outlets, wherein the one or more POMs are configured to receive the power signals, perform the DWTs of the power signals to generate the DWT coefficients associated with the power signals, and classify the power signals within the two or more classes based on the DWT coefficients; and an interchangeable monitoring device (IMD) configured to be communicatively coupled with the one or more POMs, wherein the IMD is configured to generate the one or more alert signals based on the classified power signals when the one or more alert conditions are met.

5. The power system of any of claims 1-3, wherein the power signals correspond to signals from an input source, wherein the one or more monitored devices comprise the input source, wherein the one or more controllers comprise:

one or more power input modules (PIMs) configured to receive the power signals, perform the DWTs of the power signals to generate the DWT coefficients associated with the power signals, and classify the power signals within the two or more classes based on the DWT coefficients; and an interchangeable monitoring device (IMD) configured to be communicatively coupled with the one or more PIMs, wherein the IMD is configured to generate the one or more alert signals based on the classified power signals when the one or more alert conditions are met.

6. The power system of any preceding claim, wherein the two or more classes comprise a binary set of classes, wherein the one or more normal classes include a single normal class, wherein the one or more atypical classes include a single atypical class.

7. The power system of any of claims 1-5, wherein the two or more classes comprise:
two or more sets of classes, wherein each of the two or more sets of classes corresponds to a different one of one or more device types, wherein each of the two or more sets of classes includes at least one of the one or more normal classes and at least one of the one or more atypical classes, and optionally wherein the one or more alert conditions include classification of at least one of the power signals into a class associated with a different one of the one or more device types than an expected device type.

8. The power system of any preceding claim, wherein the one or more alert conditions include classification of at least one of the power signals into one of the one or more atypical classes.

9. The power system of any preceding claim, wherein classifying the power signals within the two or more classes based on the DWT coefficients comprises:
classifying the power signals within the two or more classes based on the DWT coefficients by comparing the DWT coefficients to reference DWT coefficients using one or more metrics, and optionally:

   wherein the one or more metrics comprise at least one of a Pearson's correlation coefficient or a normalized root mean-square error; and/or wherein the reference DWT coefficients are generated based on one or more of the power signals from one or more of the monitored devices in a normal condition.

10. The power system of any of claims 1-8, wherein classifying the power signals within the two or more classes based on the DWT coefficients comprises:
classifying the power signals within the two or more classes based on the DWT coefficients using a machine learning model that accepts the DWT coefficients as inputs.

11. The power system of claim 10, wherein the machine learning model is trained on training data including at least one of labeled DWT coefficients associated with the two or more classes or RMS data associated with the one or more monitoring devices.

12. The power system of claim 11, wherein at least some of the labeled DWT coefficients associated with the two or more classes are associated with historical power signals generated by at least one of in-line monitoring circuitry or a data lake.

13. The power system of claim 11 or claim 12, wherein:

   the power signals correspond to signals between one or more output loads and one or more outlets of a power distribution sub-system including circuitry to distribute input power to the one or more outlets, wherein the one or more monitored devices comprise the one or more output loads, wherein the one or more controllers comprise:

      one or more power output modules (POMs) configured to be communicatively coupled to the one or more outlets, wherein the one or more POMs are configured to receive the power signals, perform the DWTs of the power signals to generate the DWT coefficients associated with the power signals, and classify the power signals within the two or more classes based on the DWT coefficients; and
      an interchangeable monitoring device (IMD) configured to be communicatively coupled with the one or more POMs, wherein the IMD is configured to generate the one or more alert signals based on the classified power signals when the one or more alert conditions are met; or:

   the power signals correspond to signals from an input source, wherein the one or more monitored devices comprise the input source, wherein the one or more controllers comprise:

      one or more power input modules (PIMs) configured to receive the power signals, perform the DWTs of the power signals to generate the DWT coefficients associated with the power signals, and classify the power signals within the two or more classes based on the DWT coefficients; and
      an interchangeable monitoring device (IMD) configured to be communicatively coupled with the one or more PIMs, wherein the IMD is configured to generate the one or more alert signals based on the classified power signals when the one or more alert conditions are met.

14. The power system of any preceding claim, wherein at least one of the one or more alert signals triggers at least one of a visual indicator, an audio indicator, or a remote indicator, and/or wherein at least one of the one or more alert signals directs disconnection of power to at least one of the monitoring devices.

15. A power monitoring method comprising:

receiving power signals for one or more monitored devices, wherein a respective power signal includes at least one of a current or a voltage; performing discrete wavelet transforms (DWTs) of the power signals to generate DWT coefficients associated with the power signals; classifying the power signals within two or more classes based on the DWT coefficients, wherein the two or more classes include one or more normal classes associated with one or more acceptable operational conditions and one or more atypical classes associated with one or more atypical operational conditions; and generating one or more alert signals based on the classified power signals when one or more alert conditions are met.

FIG.1

EP 4 564 632 A1

116 POM

| 202<br>PIM CURRENT<br>SENSING CIRCUITRY | 204<br>PIM VOLTAGE<br>SENSING CIRCUITRY | 206<br>PIM<br>MICROCONTROLLER |
|---|---|---|

| 208<br>PIM POWER<br>SUPPLY | 210<br>PIM<br>MEMORY |
|---|---|

FIG.2

118 POM

| 302 PIM CURRENT SENSING CIRCUITRY | 304 PIM VOLTAGE SENSING CIRCUITRY | 306 PIM MICROCONTROLLER |
|---|---|---|
| 308 POM POWER SUPPLY | 310 POM MEMORY | 312 BISTABLE RELAY |

FIG.3

EP 4 564 632 A1

120 IMD

| 402 IMD MICROPROCESSOR | 404 POM POWER SUPPLY | 406 DISPLAY INTERFACE |
|---|---|---|
| 408 FLASH MAMORY | 410 DDR MEMORY | 412 LAN ETHERNET PORT |
| 414 1-WIRE SENSOR PORT | 416 RS-232/RS-485 PORT | 418 USB PORT |
| 420 MICRO-SD SOCKET | 422 RESET SWITCH | |

FIG.4

EP 4 564 632 A1

500

502 — CAPTURING LOAD SIGNALS FOR LOADS CONNECTED TO OUTLETS

504 — PERFORMING DISCRETE WAVELET TRANSFORMS (DWTS) OF THE LOAD SIGNALS TO GENERATE DWT COEFFICIENTS

506 — CLASSIFYING THE LOAD SIGNALS INTO TWO OR MORE CLASSES BASED ON THE CORRESPONDING DWT COEFFICIENTS

508 — GENERATING ONE OR MORE ALERT SIGNALS BASED ON THE CLASSIFIED LOAD SIGNALS WHEN ONE OR MORE ALERT CONDITIONS ARE MET

FIG.5

<u>602</u>

CURRENT WAVEFORMS

<u>604</u>

DWT COEFFICIENTS

FIG.6A

606

CURRENT WAVEFORMS

............ I(ref)          I(0)

608

DWT COEFFICIENTS

............ I(ref)          I(0)

# FIG.6B

610

CURRENT WAVEFORMS

··············· I(ref)  ————— I(0)

612

DWT COEFFICIENTS

··············· I(ref)  ————— I(0)

FIG.6C

614

CURRENT WAVEFORMS

·············· I(ref)        ———— I(0)

616

DWT COEFFICIENTS

·············· I(ref)        ———— I(0)

FIG.6D

618

CURRENT WAVEFORMS

⋯⋯⋯ I(ref)　━━━ I(0)

620

DWT COEFFICIENTS

⋯⋯⋯ I(ref)　━━━ I(0)

FIG.6E

622

## CURRENT WAVEFORMS

·············· I(ref) ———— I(0)

624

## DWT COEFFICIENTS

·············· I(ref) ———— I(0)

# FIG.6F

626

CURRENT WAVEFORMS

·············· I(ref)   ————I(0)

628

DWT COEFFICIENTS

·············· I(ref)   ————I(0)

# FIG.6G

EP 4 564 632 A1

702
COLLECTING LOAD SIGNAL

704
GENERATING DWT COEFFICIENTS

706
PRE-PROCESSING DWT COEFFICIENTS

708
SAVING DWT COEFFICIENTS

710
REFERENCE DWT COEFFICIENTS EXIST?

YES

712
COMPARE DWT COEFFICIENTS

714
CLASSIFY LOAD SIGNAL

NO

716
GENERATE REFERENCE DWT COEFFICIENTS

712
COMPARE DWT COEFFICIENTS

714
CLASSIFY LOAD SIGNAL

718
RETRIEVE REFERENCE DWT COEFFICIENTS

FIG.7

FIG.8

EP 4 564 632 A1

FIG.9

FIG.10

# EUROPEAN SEARCH REPORT

**Application Number**

EP 24 21 5418

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 114 742 295 A (UNIV SICHUAN) 12 July 2022 (2022-07-12) * paragraphs [0003] - [0096] * | 1-15 | INV. H02J3/00 |
| X | CN 116 526 495 A (NANTONG ELECTRIC POWER DESIGN INST CO LTD SUPERVISION BRANCH) 1 August 2023 (2023-08-01) * paragraphs [0002] - [0055] * | 1,15 | |
| X | CN 107 123 987 A (UNIV EAST CHINA JIAOTONG) 1 September 2017 (2017-09-01) * paragraphs [0002] - [0154] * | 1,15 | |

**TECHNICAL FIELDS SEARCHED (IPC)**

H02J

The present search report has been drawn up for all claims

1

| Place of search | Date of completion of the search | Examiner |
|---|---|---|
| Munich | 31 March 2025 | Bergler, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 24 21 5418

This annex lists the patent family members relating to the patent documents cited in the above-mentioned European search report.
The members are as contained in the European Patent Office EDP file on
The European Patent Office is in no way liable for these particulars which are merely given for the purpose of information.

31-03-2025

| Patent document cited in search report | Publication date | Patent family member(s) | Publication date |
|---|---|---|---|
| CN 114742295 A | 12-07-2022 | NONE | |
| CN 116526495 A | 01-08-2023 | NONE | |
| CN 107123987 A | 01-09-2017 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63604452
- US 93677624

- US 19850423